Europäisches Patentamt

European Patent Office

Office européen des brevets

(11) Publication number: 0 181 194
A2

# EUROPEAN PATENT APPLICATION

(21) Application number: 85308029.9

(22) Date of filing: 05.11.85

(51) Int. Cl.⁴: H01J 35/00 , G03F 7/20

(30) Priority: 08.11.84 US 669441

(43) Date of publication of application:
14.05.86 Bulletin 86/20

(84) Designated Contracting States:
AT BE CH DE FR GB IT LI LU NL SE

(71) Applicant: HAMPSHIRE INSTRUMENTS, INC
10, Carlson Road
Monroe New York(US)

(72) Inventor: Forsyth, James Morton
54 Old Forge Lane
Pittsford New York 14534(US)
Inventor: Frankel, Robert David
285 Idlewood Road
Rochester New York 14618(US)

(74) Representative: Miller, Joseph et al
J. MILLER & CO. Lincoln House 296-302 High Holborn
London WC1V 7JH(GB)

(54) X-ray generating system.

(57) An X-ray lithography system (48) has a long life target in the form of a cylindrical drum (50) which is helically rotated to allow a pulsed laser beam (14) to intersect successive adjacent areas along a helix on the drum. Thus the target is moved relative to the path of the laser beam by a predefined incremental amount after a plurality of laser beam pulses have been provided to the same spot on the target.

Fig.3.

EP 0 181 194 A2

## "X-RAY GENERATING SYSTEM"

This invention relates to X-ray generating systems comprising an excitation beam whose path is directed towards a target and whose power is such as to create an X-ray emitting plasma upon striking the target. The invention has a particular application to the generation of soft X-rays for use in a commercial X-ray lithography system.

X-ray lithography systems are well known in the prior art. In US-A-3,743,842, a source of X-rays is generated by directing an electron beam against a target placed in an evacuated chamber. The beam particles are of sufficient energy so that X-ray emission is excited at the point where the beam strikes the target. The emitted X-rays, in turn, are directed towards an X-ray resist covered semiconductor substrate to expose the resist. If an X-ray mask is placed between the target and the semiconductor, a patterned exposure can be formed on the resist coated substrate.

In US-A-4,184,078, the electron beam is replaced by a laser beam pulse, which is directed towards a target to create the plasma which emits the X-rays. In the laser generated X-ray system, each time a laser pulse strikes the target, the temperature of the target material is raised to several million degrees Celsius, thereby forming the plasma. During the formation of the plasma, a certain amount of the target material is burnt away, leaving a small cavity in the target. If, in using the prior art proposals, an attempt is made to create X-rays by directing a subsequent laser pulse into the formed cavity, it has been determined that the intensity of the X-rays generated was substantially smaller. Thus, each time a new burst of X-rays was desired, either the target was moved so that the laser impinged on an unused flat area of the target or a new target was inserted. In either case, the apparatus described in the prior art is not useful in commercial applications because of the long time periods required to move the target from place to place or to replace the target while in the evacuated chamber. In present ultraviolet lithography systems, a semiconductor wafer is moved to the exposure area every one or two seconds. For X-ray lithography to be useful, it is necessary to provide a new laser shot to cause an X-ray plasma to be created each time the wafer is in position, which should be no less often than once every one or two seconds.

A significant additional problem in the prior art techniques has been the generation of a sufficient intensity of X-rays to actually expose the X-ray resist coated over the semiconductor wafer. In past techniques, the power of the laser applied to the target was so small that it was necessary to fire the laser ten or more times in order to obtain a sufficient number of X-rays to totally expose the target. It is well known that increasing the power of the laser pulse will create a hotter plasma which, in turn, generates X-rays of a greater intensity. However practical limits may prevent delivery of a sufficiently powerful laser pulse.

One can also select different materials for the target to provide the maximum intensity X-rays. However, the X-rays may be desired to be at a certain wavelength and this will limit the choice of materials.

It is preferable to have techniques available which will increase the intensity of the X-rays emitted from the plasma through the use of existing laser sources and target material.

According to the invention, therefore, an X-ray generation system comprising a excitation beam whose path is directed towards a target and whose power is such as to create an X-ray emitting plasma upon striking the target, is characterised in that the target is of a size larger than the area at which the beam strikes the target, and means is provided for causing predefined relative movement between the path of the beam and the target, whereby the path intersects different areas of the target.

In accordance with another aspect of this invention, there is provided an X-ray generating system comprising an excitation beam of a given power provided along a given path and a target of a given material having at least first and second areas for the given path to intersect. The given material and the given power are selected so that an X-ray emitting plasma is created when the beam strikes the target. In addition, the system comprises means for causing predefined relative movement between the path and the target, whereby the path intersects the first area and then the second area.

From a further aspect, the invention is an X-ray lithography system including means for providing a plurality of excitation beam pulses, means for directing the pulses towards a target means to cause an X-ray emitting plasma to be formed, means for moving an X-ray resist coated object to be irradiated by X-rays into the path of the emitted X-rays, and means for moving the target between the provision of selected beam pulses.

The scope of the invention is defined by the appended claims; and how it can be carried into effect is hereinafter particularly described with reference to the accompanying drawings, in which:-

Figure 1 shows diagrammatically X-ray generating system;

Figures 2A, 2B, 2C and 2D illustrate the formation of a cavity in the target after several applications of a laser pulse to the target;

Figure 3 shows diagrammatically a first embodiment of an X-ray lithography system incorporating the invention, and

Figure 4 shows diagrammatically a second embodiment of X-ray lithography system incorporating the invention.

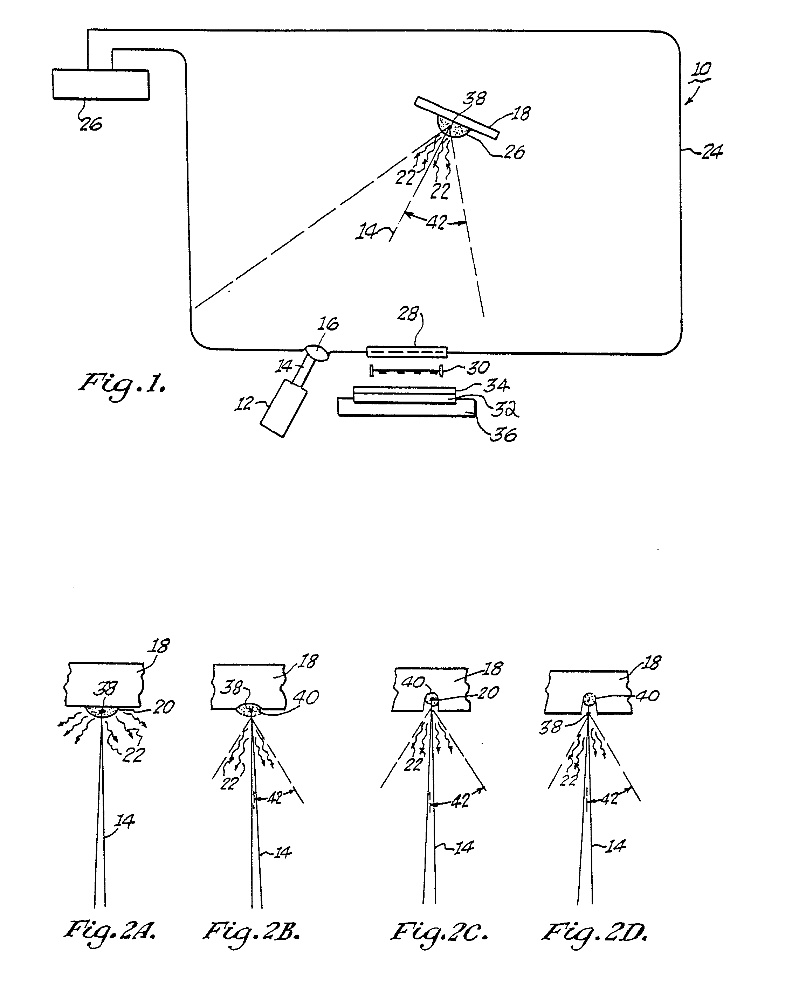

An X-ray lithography system 10 (Figure 1) includes a laser generator 12 which generates a high powered pulse laser beam 14 focussed by a lens 16 onto a target 18, which may be of a material such as aluminium or stainless steel. The power contained in the laser beam pulse focussed on the target 18 should be sufficient to cause a plasma to be created on the target 18. The plasma in turn will generate soft X-rays in the range of 0.2 to 2nm depending upon the material of target 18.

The target 18 must be an evacuated chamber 24 which may be maintained at a pressure of 1.333224 Pa (0.01 Torr) by a vacuum pump 26. The lens 16 may be positioned in the outer wall of the chamber 24. An X-ray transparent window 28 is also provided in the bottom of the chamber 24 to allow the X-rays 22 to travel from the interior of chamber 24 to the exterior thereof. The window 28 may be of a suitable solid material, such as beryllium, which is transparent to X-rays or it may be an opening closed by an aerodynamic jet stream of gas such as described in co-pending patent application No. 85307889.7.

External to the chamber 24 is an X-ray mask 30 to provide an image of X-rays to a semiconductor wafer 32 covered by X-ray resist material 34. Wafer handler means 36 is provided to move the wafer to various positions so that different areas may be exposed to the pattern of X-rays defined by the mask 30. Suitable wafer handling equipment is shown in U.S-A-4,444,492.

The system 10, as thus far described, is typical of the prior art of US-A-3,743,842 and US-A-4,184,078, and operates by a single pulse from laser 12 along the beam 14 being provided and focussed by lens 16 at a spot 38 of target 18. The focussed laser pulse creates a plasma 20 which emits X-rays 22. The X-rays travel throughout chamber 24 and in particular through window 28 and mask 30 to cause a pattern to be exposed on photoresist 34. In the prior art, the target 18 is either manually moved or replaced after each laser pulse is applied thereto and the same procedure repeated. Due to the long length of time required to manually move or replace target 18, the practicalities of using the prior art versions of system 10 are quite limited. Conventional lithography equipment, such as the photolithography systems described in US-A-4,444,492, include wafer handling means 36 which allow exposures to occur approximately every two seconds. Advantage cannot be taken of this, because of the long time required to manually move or replace target 18.

The teachings of the prior art also suggest that it is improper to provide more than one pulse from laser 12 towards the same spot 38 on target 18. Each time a pulse is applied and a plasma created, a certain amount of material of target 18 is burnt away due to the tremendous heat of the plasma. This results in a cavity being formed on the surface of target 18 at spot 38 where laser beam 14 strikes target 18. In the past when experimenters have tried to direct a second laser beam into the cavity so formed, a much lower intensity of X-rays resulted. In these experiments, the detector for X-ray intensity was placed at an angle equal to or greater than 45 degrees away from the path of beam 14.

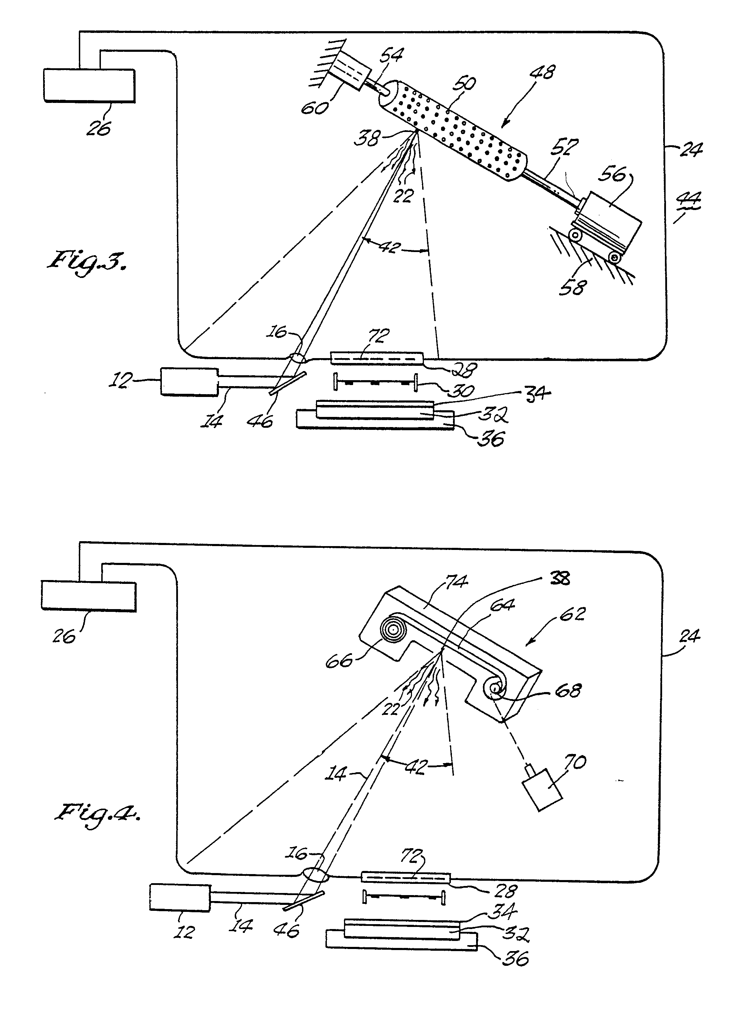

In explanation of what occurs when a series of laser beam pulses is applied to target 18, the laser beam 14 (Figure 2A) strikes target 18 at spot 38 causing a plasma 20 to be created essentially on the outer surface of target 18, and X-rays 22 to be emitted from the plasma 20. The X-rays 22 are provided with an approximately uniform intensity throughout the entire area below target 18. After the plasma 20 has dissipated, a cavity 40 (Figure 2B) is formed. As additional laser pulses are applied against target 18 and focussed on spot 38, cavity 40 increases in depth, plasma 20 is created within the cavity 40 until, as shown in Figures 2C and 2D, plasma 20 is wholly within cavity 40. Laser pulses could continue to be focussed on point 38 and cavity 40 would become deeper as shown in Figure 2D.

As cavity 40 increases in depth and plasma 20 is formed within the cavity, the temperature of plasma 20 increases due to the more confined area in which it is formed. This causes a greater intensity of X-rays to be emitted. In addition, these X-rays are confined to a certain cone surrounding laser beam 14 and represented by the conical angle 42 (Figures 2B, 2C and 2D). Thus, the intensity of the X-rays within the cone defined by angle 42 is significantly greater than the intensity of the X-rays beyond the cone defined by angle 42, which is signficantly less than the intensity of the X-rays originally emitted (Figure 2A). This phenomenon of a significantly higher intensity of X-rays within the cone defined by angle 42 escaped detection in the prior art experimentations because of the positioning of the X-ray detector outside the cone defined by angle 42.

As the depth of cavity 40 increases, the angle of the cone defined by angle 42 decreases. X-rays are absorbed into the side of the cavity wall, thereby creating additional heat. The higher plasma density caused by the confinement of the cavity walls causes the plasma in the cavity to act more as an ideal radiator, thereby increasing the intensity of the X-rays.

Experiments have shown that cavities which produce significant increases in X-ray output will be deep enough below the spot 38 to cause angle 42 to be approximately 45 degrees. If the cavity is preformed by a focussed laser pulse, successive laser pulses focussed into the cavity will cause the cavity to become deeper, reducing the available cone angle 42. The intensity of the X-rays within the cone defined by angle 42 may be two or more times greater than the intensity of the X-rays emitted from plasma on the surface (Figure 2A). Repeated irradiation of the cavity by many laser pulses eventually causes the X-ray emission within the cone angle 42 to decline. This occurs because the outer walls of the cavity serve as a heat sink for the hot plasma created at the bottom of the cavity. This colder material acts to absorb some of the X-ray radiation under these conditions. Empirically, a range of cavity depths produced by one or more focussed laser pulses of from 0.3 to 0.8 mm is found to produce significantly enhanced X-ray emission within cone angle 42.

In order to take advantage of the phenomenon of the higher intensity X-rays within the cone defined by angle 42, laser 12 (Figure 1) and lens 16 are positioned so that the window 28, mask 30 and the portion of semiconductor wafer 32 being exposed are all positioned within the critical angle 42 of the cone of high intensity X-rays. This requires that lens 16 be placed in close proximity to window 28. This may require the use of directing mirrors so that laser 12 does not interfere with the wafer handling device 36 as it moves wafer 34 between the various positions to be exposed.

By placing mask 30 and the area of wafer 32 which is to be exposed within the cone defined by angle 42, significant advantages are achieved. First a lower powered laser 12 may be used to generate the necessary intensity of X-rays to expose the X ray resist 34. Further, with a higher intensity of X-rays, different types of X-ray resist material may be used. Further, the ability to direct a plurality of laser pulses at the same spot allows multiple exposures to be obtained without having to move or replace target 18.

In a second embodiment of the invention (Figure 3), a different configuration target is shown which can be mechanically moved so that a large quantity of X-ray exposures can be easily and automatically obtained without having to physically change the target. The X-ray lithography system 44 includes a mirror 46 for directing the laser beam 14 from laser 12 through lens 16. The target 18 of Figure 1 is replaced by a target system 48. Target system 48 includes a cylindrical drum 50 constructed of an appropriate material useful as a target. Such material may be aluminium or stainless steel, as previously mentioned. Attached to the ends of cylinder 50 are a shaft 52 and a threaded rod 54. A motor 56 is attached to shaft 52 to rotate the shaft 52, and drum 50. The motor 56 rides on a rail 58 aligned with the common axis of drum 50, shaft 52 and rod 54. Threaded rod 54, which is attached to the other end of cylinder 50, is engaged in a stationary threaded nut 60. As motor 56 rotates shaft 52, drum 50 and rod 54, the engagement of the nut 60 and rod 54 causes endwise movement of the entire target system 48. During this movement, motor 56 rides along rails 58.

In operation, cylindrical drum 50 is positioned so that laser beam 14 is focussed initially on a spot close to one end thereof. After an appropriate number of laser pulses have been applied to a particular spot on drum 50, drum 50 is rotated a small amount. This allows a new series of pulses to be applied to a point just adjacent to the prior spot to which the laser pulses were previously applied. As drum 50 continues to be rotated a small amount each time, a helical path of target spots is formed. The amount by which drum 50 is rotated is determined by the diameter of the cavity 40 (Figures 2B, 2C, and 2D). As cavity 40 is of a very small size, 0.5 mm or less, the number of cavities permitted per rotation of drum 50 is great. Of course the size of drum 50 will determine the actual number of available spots to create cavities. Further the lateral movement per rotation will be quite small. The actual size of drum 50 can be selected so that a large number of target positions can be obtained. This will allow the target to be used for a long period of time before replacement is necessary.

In another embodiment of the invention (Figure 4) an alternative target system 62 replaces the target system 48. Target system 62 includes an elongated target strip 64, which initially is almost wholly wound around a feed reel 66, having a run across the target area to a take-up reel 68. Take-up reel 68 is driven by a motor 70 to cause strip 66 to move in short increments past spot 38 at which laser beam 14 is focussed. Target system 62 may be fabricated into a cassette 74 for easy removal and replacement. Lateral movement of the cassette 74 transverse to the length of the strip 66 may also be provided to increase the number of target spots available. Alternatively, means associated with the mirror 46 could move the mirror by incremental amounts to direct the laser beam pulses at selected locations perpendicular to the path of movement of strip 64.

In using either the long life target system 48 (Figure 3) or the target system 62 (Figure 4), it is necessary to provide the initial cavity 40 on the target. This may be accomplished by providing an initial laser pulse to either drum 50 or strip 64 while blocking the X-rays provided through window 28 from reaching mask 30. Such blockage may be accomplished by providing a shutter 72 within window 28. Shutter 72 may be an X-ray absorbing material strobed across window 28 in conjunction with the formation of cavity 40. In the alternative, a higher energy laser beam pulse could be provided initially to cause a greater intensity of X-rays throughout the entire area of chamber 24. Thereafter, lower energy laser pulses would be provided. By controlling the energy within each of the laser pulses provided against the target drum 50 or strip 64, the intensity of the X-rays passing through window 28 can be controlled. Further, an initialization procedure could be used to create all the initial cavities before the chip handling means 36 moves the chip 32 into position. If such a procedure were utilized, means would be required to initialize the target position so that after initialization, laser pulses would be directed into the preformed cavities. The cavities provide a volume for the expansion of the target to occur.

## Claims

1. An X-ray generating system comprising an excitation beam whose path (14) is directed towards a target (50,64) and whose power is such as to create an X-ray emitting plasma (20) upon striking the target, characterised in that the target (50,64) is of a size larger than the area at which the beam (14) strikes the target, and means (56,70) is provided for causing predefined relative movement between the path of the beam and the target, whereby the path intersects different areas of the target.

2. A system according to claim 1 in which the predefined movement is such that successive intersection areas are adjacent to one another.

3. A system according to claim 1 or 2 in which the predefined movement is such that successive intersection areas follow a predetermined path on the target.

4. A system according to any preceding claim, in which the relative movement is caused by moving the target.

5. A system according to claim 4 in which the target is a rotatable cylinder (50).

6. A system according to claim 5 in which the cylinder (50) is movable along its longitudinal axis as it is rotated.

7. A system according to claim 1, 2 or 3, in which the target is a strip (64) extending between a feed spool on a reel (66) and a receiving spool on a take-up reel (68), and longitudinally movable therein.

8. A system according to claim 7, in which the intersection of the beam with the strip is movable transversely of the longitudinal movement of the strip.

9. A system according to claim 7, in which the transverse movement of the intersection is effected by movement of the strip.

10. A system according to claim 7, 8 or 9, in which the supply reel (66), take-up reel (68) and strip (64) are within an enclosure forming a cassette (74).

11. A system according to any preceding claim, in which the excitation beam is in the form of a succession of power pulses.

12. A system according to claim 11, in which the means for causing relative movement between the target and beam is operative between the provision of selected pulses.

13. A system according to any preceding claim, in which the target includes a plurality of preformed cavities therein, the cavities providing a volume for the expansion of the target to occur.

0 181 194

*Fig.1.*

*Fig.2A.*   *Fig.2B.*   *Fig.2C.*   *Fig.2D.*

0 181 194

Fig.3.

Fig.4.